# EUROPEAN PATENT APPLICATION

(11) **EP 2 048 928 A2**
(43) Date of publication of application: **15.04.2009**
(21) Application number: 08166039.1
(22) Date of filing: 07.10.2008
(51) Int. Cl.: H05K 7/20

(54) **Heat removal from electrical modules**

(30) Priority: 09.10.2007 GB 0719698
(71) Applicant: Vetco Gray Controls Limited, Bristol BS48 1BS (GB)
(72) Inventor: Gough, Robert John, Weston-super-Mare, Somerset BS22 7YF (GB)
(74) Representative: Emerson, Peter James

(57) **Abstract**

An electronics assembly for an underwater well installation, comprises a housing; an electrical module located within the housing; and a resiliently deformable member located between the electrical module and the housing for conducting heat between the electrical module and the housing.

## Description

This invention relates to an electronics assembly for an underwater well installation and a method of providing a heat transfer mechanism for an electrical module of an underwater well installation.

Subsea Electronic Modules (SEMs), which are employed in the control systems for production hydrocarbon fluid extraction wells, contain electronic power supplies and components that in use generate a substantial amount of heat. The current requirement for more sophistication in control and monitoring of hydrocarbon wells has resulted in a significant increase in power requirement. Generally, it is more cost effective to replace a failed unit from an existing system with a modem version of the SEM rather than stock or manufacture the earlier designs of SEMs. In this case it is necessary to retain both physical and electrical compatibility with existing SEMs. However, the increased power dissipated in the SEM internal power module results in a greater power / volume density, which creates difficulty in removing the heat to sustain sensible operating temperatures. SEMs are typically cylindrical and housed in a cylindrical container. The electronic power module is also assembled as a cylindrical module which fits into the housing. Additionally, SEMs comprise banks of electronic cards which are mounted in one or more card frames whose outer surface is cylindrical in order to fit into the cylindrical housing. Heat is conducted to each card frame by a variety of techniques, such as the use of thermal planes on the cards and thermally conducting wedges in the card supporting slots in the card frame. Such card frame assemblies are generally referred to as electronic modules hereafter. Removal of heat is dependent on its transfer to the housing which implies a tight fit between the housing and the module, which is impractical both in view of the manufacturing tolerances required and their differential expansion in operation. Previous attempts to solve the problem have involved leaving a small gap between the module and the housing and filling this gap with a thermally conductive paste. However, this still involves expensive high manufacturing tolerances, and is unreliable under differential expansion conditions.

It is an object of the present invention to provide an effective method of conducting the heat from the power module and / or an electronic card frame to the housing whist removing the need for high manufacturing tolerances, and still allowing maximisation of module volume and providing a sound mechanical mounting.

This object is met by employing at least one resiliently deformable member located between the power module and / or an electronic card frame and the housing, made from a good thermal conducting material, which transfers heat from the power module and / or an electronic card frame to the housing without the need for high manufacturing tolerances and providing good mechanical coupling between them.

In this way, the present invention provides various advantages over the prior art, including:
1) Removal of the need for high tolerance power module / card frame / housing manufacture;
2) Removal of the need for unreliable, difficult to apply, thermal conducting fillers/pastes; and
3) The provision of a sound mechanical coupling between the power module and / or an electronic card frame and the housing whilst permitting easy disassembly.

In accordance with a first aspect of the present invention there is provided an electronics assembly for an underwater well installation, comprising:
a housing;
an electrical module located within the housing; and
a resiliently deformable member located between the electrical module and the housing for conducting heat between the electrical module and the housing.

In accordance with a second aspect of the present invention there is provided a method of providing a heat transfer mechanism for an electrical module of an underwater well installation, the module being retained within a housing in use, comprising the step of:
locating a resiliently deformable member between the electrical module and the housing, for conducting heat between the electrical module and the housing.

Advantageously, the module is a power supply module of a subsea electronics module.

Preferably, the resiliently deformable member comprises a spring. This may be coiled around an axis and canted. In this case, the canted spring may be arranged with its axis positioned around a perimeter of the electrical module.

A plurality of resiliently deformable members may be located between the electrical module and the housing.

The invention will now be described, by way of example, with reference to the accompanying drawings, in which:-
Fig. 1a schematically shows a cross-section of a SEM assembly in accordance with a first embodiment of the present invention;
Fig. 1b shows a detail view of the apparatus of Fig. 1a;
Fig. 2a schematically shows a cross-section of a SEM in accordance with a second embodiment of the present invention;
Fig. 2b shows a detailed view of a portion of Fig. 2a; and
Fig. 2c schematically shows a cross-section of the SEM of Fig. 2 a along the lines A-A.

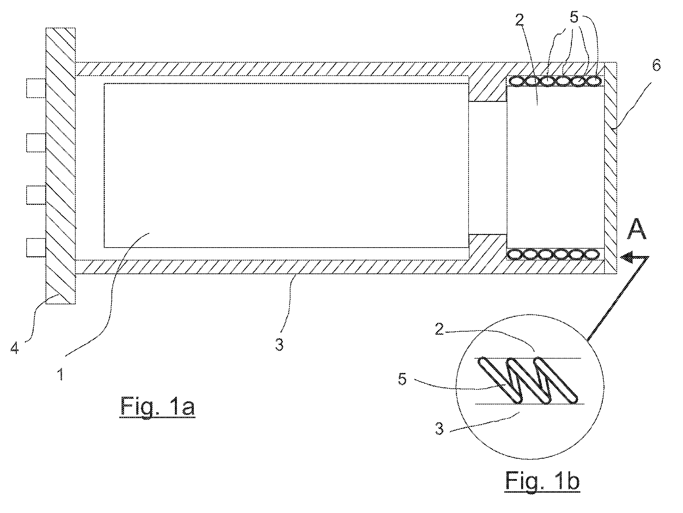

Fig. 1a shows a simplified section through a SEM assembly in accordance with a first embodiment of the present invention, which provides a heat transfer mechanism for a power module of a SEM. At least one electronics module 1 and a power module 2 are located within a cylindrical housing 3, separated by a radial inward-protruding collar of the housing 3. The housing 3 includes an end plate 4 with electrical interface connectors mounted thereon. An end plate 6 is used to close the other end of housing 3. The power module 2 is supported within the housing 3 by a plurality of resiliently deformable members, which in this example comprise a set of circular canted springs 5. These are coiled, and arranged with their axes around the circular perimeter of the power module 2. The springs 5 are formed from a material of good thermal conductivity. An example of a suitable material for the canted springs 5 is beryllium copper.

Fig 1b illustrates, for clarity, a short section of a spring 5 within the gap between the power module 2 and the housing 3, showing that it is canted with the cant angle varying according to the width of the gap between the module 2 and housing 3. The arrow 'A' shows the direction of the view of Fig 1a with the end cap 6 removed. The canting of the spring 5 enables the width of the coil to vary, so that the spring 5 automatically adjusts to the gap created by the tolerance of the cylindrical dimensions of the power module 2 and the housing 3. In this way, as the power module is inserted into the housing 3 prior to fitting the end cap 6, the springs 5 distort, thus providing both mechanical support and good thermal conduction of the heat from the power module 2 to the housing 3 where it can be dissipated.

The above-described embodiment is exemplary only, and various alternatives are possible within the scope of the claims. For example, various forms of resiliently deformable members may be used, such as leaf-type springs. Instead of sets of circular springs, a single spring could be used, wrapped around the module several turns. In a further alternative, the spring or springs may be used to support thermally conducting pads in contact with the bore of the housing. This alternative provides a greater contact area between the housing and the or each spring. Although the invention is described with reference to a power module of a SEM, the invention could be applied to the electronics module 1, or to equipment other than a SEM. To aid mechanical integrity, the or each spring may be attached to the respective module, i.e. power module or electronics module using adhesive.

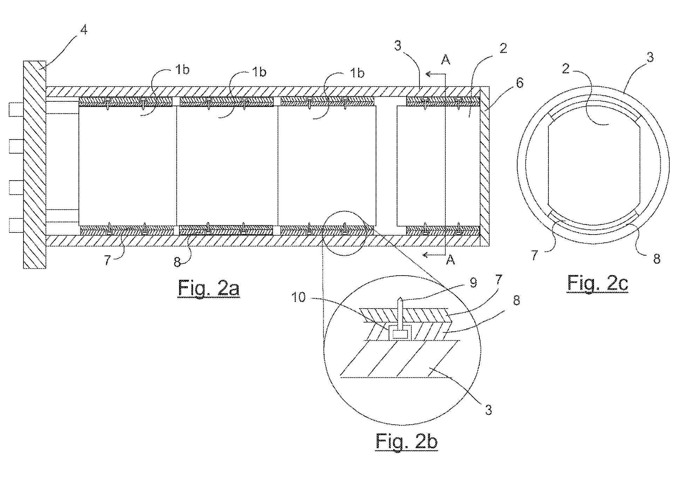

A second embodiment of the present invention is shown in Figs. 2a-2c. Here, components similar to those of Fig. 1 will retain the same reference numbering as far as possible. The embodiment shown provides a mechanism for heat transfer from both a power module 2 and an electronics module of a SEM. In Fig. 2a, the electronics module is shown in more detail, so that three separate card frame bays 1b of the module can be seen. In use, each bay 1b would typically include a number of parallel-stacked electronics cards in a frame. In addition, in the SEM shown, the power module 2 and electronics module 1 may be formed as a unitary component. For this reason, the SEM housing 3 is shown without the radial inward-protruding collar present in Fig. 1, i.e. in the SEM of Fig. 2, the housing 3 has a substantially constant internal diameter.

Thermal conducting, resiliently deformable spongy material 7 is sandwiched between the metal body of the card frames within each bay 1b and a curved metal plate 8. Metal plate 8 may typically be made from aluminium and is accurately machined with a radius on its outer surface to match the radius of the inside of the SEM housing 3 in order to provide a good thermal contact therebetween. Plate 8 is secured to its respective card frame by screws 9 through counter-bored holes 10 in the plate 8. The counter bores 10 allow radial movement of plates 8 relative to the frame assembly, which movement compresses the spongy material 7. The same arrangement is used with respect to the power module 2.

To assemble the SEM, the card frames and power module 2 are connected together, and both are fitted with the surrounding spongy material 7 and plates 8. The unit is then attached to end plate 4 and inserted into housing 3. This results in compression of the spongy material 7 which acts as a spring to press the plates 8 against the internal surface of housing 3, to ensure good thermal contact. The plates 8 have a small chamfer on their edges (not shown), to facilitate the insertion of the assembly into the housing 3. After the assembly has been inserted, the SEM is purged with moisture-free nitrogen via a port in the end plate 4.

The use of spongy material as in this second embodiment is currently preferred to the use of springs as in the first embodiment, since the SEM is mechanically more robust. Furthermore, no adhesive is required, which could adversely affect the heat transfer properties, and the thermal path provided by the spongy material is generally greater than that achievable using spring material.

An example of suitable spongy material is supplied by T-Global Technology Co., reference L37-TS, which is available in thickness from about 0.5 to about 15 mm and has a thermal conductivity of about 1.7 W/m.k with a working temperature range from about -50 to +220 degrees C.

Various alternatives to this embodiment are possible within the scope of the claims. For example, the provision of such a heat-transfer path may be applied to the electronics module and / or power module alone or in combination.

## Claims

1. An electronics assembly for an underwater well installation, comprising:
a housing;
an electrical module located within the housing; and
a resiliently deformable member located between the electrical module and the housing for conducting heat between the electrical module and the housing.

2. A method of providing a heat transfer mechanism for an electrical module of an underwater well installation, the module being retained within a housing in use, comprising the step of:
locating a resiliently deformable member between the electrical module and the housing, for conducting heat between the electrical module and the housing.

3. An assembly according to claim 1 or method according to claim 2, wherein the module is a power supply module of a subsea electronics module.

4. An assembly according to claim 1 or method according to claim 2, wherein the module is an electronics module.

5. An assembly according to any of claims 1 or 3 to 4 or a method according to any of claims 2 to 4, wherein the resiliently deformable member comprises a spring.

6. An assembly or method according to claim 5, wherein the spring is coiled around an axis and canted.

7. An assembly or method according to claim 6, wherein the canted spring is arranged with its axis positioned around a perimeter of the electrical module.

8. An assembly according to any of claim 1 or 3 to 7, or a method according to any of claims 2 to 7, comprising a plurality of resiliently deformable members located between the electrical module and the housing.

9. An assembly according to any of claim 1 or 3 to 8, or a method according to any of claims 2 to 8, wherein the or each resiliently deformable member supports a thermally conducting pad in contact with the housing.

10. An assembly according to either of claims 1 and 3 or a method according to either of claims 2 and 3, wherein the resiliently deformable member comprises a spongy material.

11. An assembly or method according to claim 10, wherein the spongy material is held against the electrical module by at least one surrounding plate.

12. An assembly or method according to claim 11, wherein the or each plate is attached to the electrical module allowing relative movement therebetween.

13. An assembly or method according to either of claims 11 and 12, wherein the or each plate is thermally conducting.
